# DEMANDE DE BREVET EUROPEEN

(11) **EP 0 800 314 A1**
(43) Date de publication de la demande: **08.10.1997**
(21) Numéro de dépôt: 97400766.8
(22) Date de dépôt: 03.04.1997
(51) Int. Cl.: H04N 7/20, H03D 7/16

(54) **Dispositif de réception de programmes émis par un satellite ou par une station MMDS**

(30) Priorité: 05.04.1996 FR 9604325
(71) Demandeur: THOMSON multimedia, 92648 Boulogne Cédex (FR)
(72) Inventeur: Harrison, David, 92648 Boulogne Cedex (FR); Guo, Chaoying, 92648 Boulogne Cedex (FR)
(74) Mandataire: Ruellan-Lemonnier, Brigitte

(57) **Abrégé**

La présente invention se situe dans le domaine des transmissions d'informations numériques ou analogiques émises par un satellite ou par une station MMDS ( Multi-point Multi-channel Distribution Systems en langue anglaise) et concerne particulièrement un dispositif de réception d'informations audiovisuelles comportant un étage convertisseur SHF à faible bruit (LNB, Low noise converter-block en langue anglaise) solidaire d'une antenne située à l'extérieur d'une habitation et reliée par un câble coaxial à une unité située à l'intérieur de ladite habitation. Celle-ci recevant des programmes audiovisuels émis à travers une pluralité de canaux de transmission.

Selon l'invention, l'étage LNB comporte au moins un module de sélection de la gamme de fréquence de fonctionnement de l'appareil de réception.

## Description

La présente invention se situe dans le domaine des transmissions d'informations numériques ou analogiques émises par un satellite ou par une station MMDS (Multi-point Multi-channel Distribution Systems en langue anglaise).

L'invention concerne particulièrement un dispositif de réception d'informations audiovisuelles comportant un étage convertisseur SHF à faible bruit (LNB, Low noise converter-block en langue anglaise) solidaire d'une antenne située à l'extérieure d'une habitation et reliée par un câble coaxial à une unité située à l'intérieure de ladite habitation. L'habitation est une maison individuelle ou un ensemble d'appartements comprenant au moins un appareil d'utilisation des informations reçues tels que par exemple un téléviseur et/ou un magnétoscope recevant par exemple des programmes audiovisuels émis dans une gamme de fréquence déterminée.

Les dispositifs de réception de ce type, connus dans l'art antérieur, sont généralement séparés en deux unités distinctes, une unité extérieure (Outdoor unit en langue anglaise) et une unité intérieure (Indoor unit en langue anglaise). L'unité extérieure comporte généralement une antenne satellite ou une antenne MMDS, un LNB ainsi qu'un système d'orientation de l'antenne. L'unité intérieure comporte un ou plusieurs tuners et un ou plusieurs démodulateurs/décodeurs reliés à un ou à plusieurs appareils d'utilisation tels que des téléviseurs et/ou des magnétoscopes.

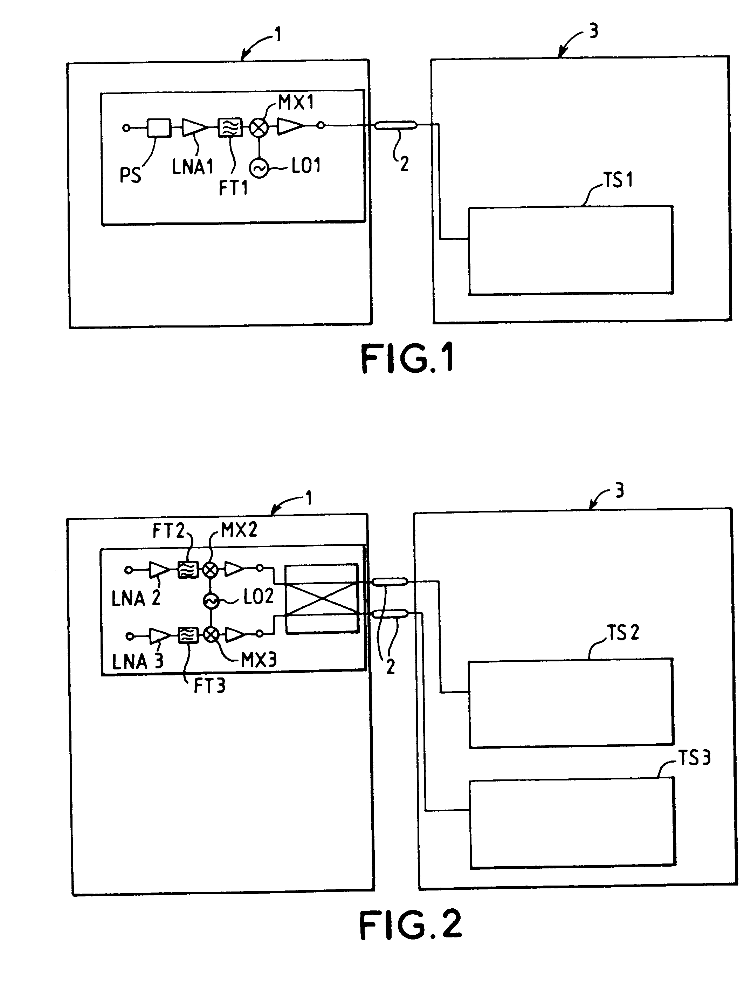

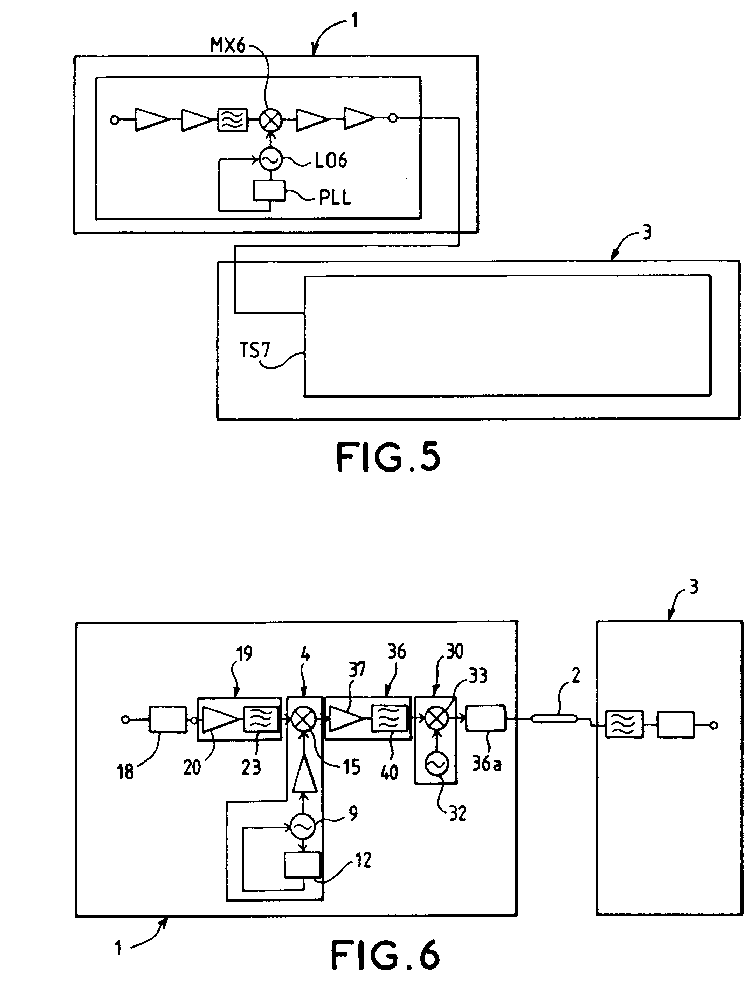

Les figures 1 à 4 représentent des schémas de dispositifs connus, utilisés pour recevoir des informations émises par un satellite, tandis que la figure 5 représente un schéma d'un dispositif, également connu, utilisé pour recevoir des informations émises par une station MMDS.

Dans la suite de cette description, le terme canal désigne un intervalle de fréquences centré autour d'une fréquence porteuse, relativement basse par rapport aux fréquences reçues par l'antenne et, correspondant à une gamme de fréquence de fonctionnement des appareils de réception selon le standard en cours.

L'exemple illustré par le schéma de la figure 1 représente schématiquement le système Européen DBS (Direct Broadcast Satellite) prévu pour recevoir des signaux dont les fréquences sont situées dans une bande de fréquence allant de 11,7 GHz à 12,50 GHz. Cette bande de fréquence est convertie, au moyen d'un oscillateur local LO1 relié à un mixer MX1 agencé dans le LNB 1, en une bande unique de fréquences intermédiaires s'étendant entre 950 MHz et 1750 MHz et comportant plusieurs canaux de réception. Une sélection de polarisation est réalisée par un signal de 12/18 V envoyé de l'unité intérieure vers un étage de sélection de polarisation PS située dans l'unité extérieure. Un amplificateur à faible bruit LNA1 (Low Noise Amplifier en langue anglaise) est agencé entre l'étage PS et un filtre de réjection de la bande image FT1. Un moyen de sélection du canal de transmission est prévu dans le tuner du satellite TS1 agencé dans l'unité intérieure. Cette dernière est reliée à l'unité extérieure par un câble coaxial 2.

La figure 2 illustre un dispositif permettant de recevoir simultanément, sur deux appareils d'utilisation, des programmes émis par deux satellites partageant la même bande de fréquences mais utilisant des polarisations différentes. Un exemple typique d'un tel dispositif est le système de réception pour les satellites TDF1 et TV-SAT. Ce type de réception est rendu possible par l'utilisation de deux tuners satellites TS2 et TS3 reliés chacun à un appareil d'utilisation. Le LNB 1 comporte, de façon connue en soi, deux amplificateurs à faible bruit LNA2 et LNA3 reliés respectivement à un filtre de réjection de la bande image FT2 et FT3. Les sorties de chacun des filtres FT2 et FT3 sont reliées respectivement à un mixer MX2 et MX3 associés à un oscillateur local LO2. Le LNB 1 reçoit des signaux dont les fréquences sont situées dans une bande de fréquences SHF et délivre à l'unité intérieure deux bandes de fréquences intermédiaires s'étendant de 950 MHz à 1750 MHz. Un moyen de sélection du canal de transmission souhaité par l'utilisateur est prévu dans les tuners du satellite TS2 et TS3 agencé dans l'unité intérieure. Cette dernière est reliée à l'unité extérieure par deux câbles coaxiaux.

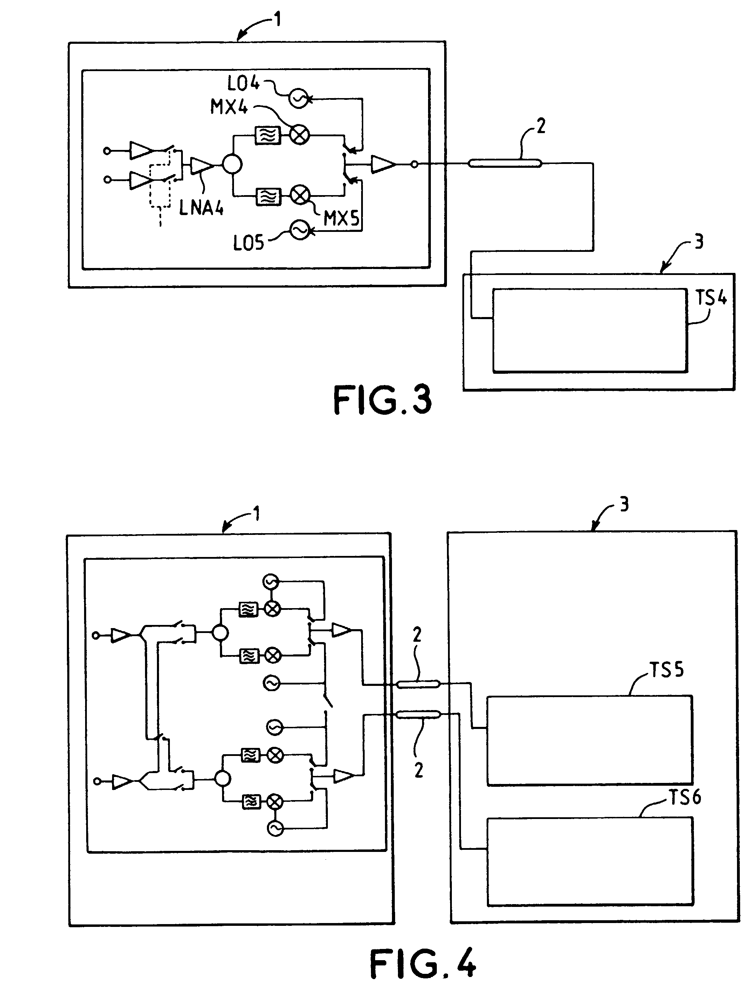

La figure 3 illustre un dispositif permettant de recevoir une bande unique de fréquences allant de 10.7 GHz à 12.5 GHz. Dans ce cas, le LNB 1 comporte deux oscillateurs locaux LO4 et LO5 associés respectivement à un mixer MX4 et à un mixer MX5 pour convertir la bande de fréquences reçue en deux bandes de fréquences intermédiaires situées respectivement entre 950 MHz et 2050 MHz et entre 1100 MHz et 1990 MHz. Les signaux transportés dans lesdites bandes de fréquences intermédiaires sont ensuite transmis à l'unité intérieure via un câble coaxial. Un exemple de ce type de dispositif est le nouveau système de réception pour le satellite ASTRA.

Le choix de l'un des deux oscillateurs locaux est réalisé par un signal de 22 KHz transmis à partir de l'unité intérieure à un sélecteur de polarisation, non représenté, monté en amont d'un amplificateur à faible bruit LNA4. Un moyen de sélection du canal ou des canaux de transmission souhaité(s) par un utilisateur est prévu dans le tuner du satellite TS4.

La figure 4 illustre schématiquement le système de réception du satellite ASTRA 1A, 1B, 1C, 1D, 1E et 1F. Un tel dispositif permet de recevoir une bande de fréquences allant de 10.7 GHz à 12.5 GHz et de transmettre simultanément, à deux appareils d'utilisation situés dans l'unité intérieure, deux bandes de fréquences situées respectivement entre 950 MHz et 2050 MHz et entre 1100 MHz et 1990 MHz. La sélection du canal de transmission souhaité par l'utilisateur est réalisée dans les tuners du satellite TS5 et TS6 situés dans l'unité intérieure.

La figure 5 illustre un dispositif permettant de recevoir une bande de fréquence allant de 2,5 GHz à 2,686 GHz par une station MMDS. La bande de fréquences reçue est ensuite convertie par le LNB 1 en bandes de fréquences UHF (Ultra High Frequency en langue anglaise) ou VHF ( Very High Frequency en langue anglaise) transmises à l'unité intérieure. Chaque bande UHF ou VHF comporte plusieurs canaux de réception. La sélection du canal de réception souhaité par l'utilisateur est réalisée dans le tuner MMDS TS7 située dans l'unité intérieure. L'unité extérieure comporte de façon connue en soi, un bloc de conversion de fréquence comprenant un oscillateur local LO6 commandé par un circuit PLL et relié à un mixer MX6.

Outre la complexité de leurs structures, les dispositifs de l'art antérieur présentent des pertes d'énergie non négligeables dans le ou les câble(s) coaxial(aux) dans la mesure où les signaux transmis entre l'unité extérieure et l'unité intérieure ont des fréquences relativement élevées. De ce fait, il est nécessaire d'utiliser un dispositif de contrôle automatique de gain AGC (automatic gain control en langue anglaise) afin de compenser lesdites pertes pour les différentes longueurs du câble dans les différents types d'installation. Ceci contribue à l'accroissement du coût de tels dispositifs.

Le but de l'invention est de pallier les insuffisances des dispositifs de l'art antérieur au moyen d'un dispositif de réception de faible coût permettant, d'une part, de limiter les pertes dans le câble coaxial et, d'autre part, de réduire le nombre d'étages électroniques dans l'unité intérieure.

Selon l'invention, l'étage LNB 1 comporte au moins un module de sélection de la gamme de fréquence de fonctionnement de l'appareil de réception.

Grâce à l'invention, les pertes dans le câble sont réduites dans la mesure où l'étage LNB 1 délivre à l'unité intérieure uniquement la ou les fréquence(s) du canal ou des canaux sélectionnés qui sont relativement basses par rapport aux fréquences reçues par l'antenne extérieure. Il en résulte que l'utilisation d'un AGC n'est plus nécessaire dans le dispositif selon l'invention.

En outre, l'unité intérieure est notablement allégée du fait qu'elle comporte uniquement un démodulateur/décodeur associé à un moyen de filtrage. Ledit démodulateur/décodeur peut être aisément adapté à la réception de données numériques ou à la réception de données analogiques.

D'autres caractéristiques et avantages de l'invention ressortiront de la description qui va suivre, prise à titre d'exemple non limitatif, en référence aux figures annexées dans lesquelles :
- Les figures 1 à 4 représentent schématiquement et partiellement des dispositifs de l'art antérieur permettant de recevoir des programmes émis par satellite.
- La figure 5 représente scématiquement et partiellement un dispositif de l'art antérieur permettant de recevoir des programmes émis par une station MMDS.
- La figure 6 représente un dispositif de réception selon un premier mode de réalisation de l'invention.
- La figure 7 représente une variante du dispositif de réception de la figure 6.

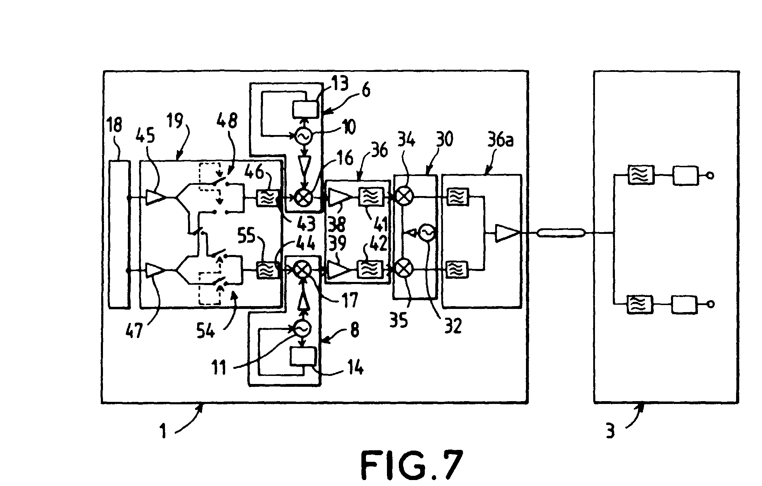

Les figures 6 et 7 représentent un dispositif de réception d'informations audiovisuelles émises par un satellite ou par un station MMDS. Chacun desdits dispositifs comporte un étage LNB 1 solidaire d'une antenne extérieure, non représentée, reliée par un câble coaxial 2, à une unité intérieure 3 comprenant au moins un appareil d'utilisation des informations reçues, fonctionnant dans une gamme de fréquence déterminée.

Selon une première caractéristique de l'invention, l'étage LNB 1 comporte au moins un module (4;6;8) de sélection de la gamme de fréquence de fonctionnement de l'appareil de réception. Ledit module (4;6;8) comporte un premier oscillateur local (9;10;11) commandé par un circuit PLL (12;13;14) de manière à fournir un signal S1, de fréquence f1 prédéterminée, à un mélangeur de fréquence (15;16;17).

Selon un premier mode de réalisation de l'invention illustré par la figure 6, l'étage LNB 1 comporte un étage de sélection de polarisation 18 ayant une entrée reliée à l'antenne de réception et une sortie reliée à l'entrée d'un premier module d'amplification/filtrage 19 comprenant un LNA à large bande 20 et un premier filtre de réjection de la bande image 23. Ledit premier module d'amplification/filtrage 19 est relié au module 4 de sélection de la bande de fréquences du canal adapté à l'appareil de réception . Le premier mélangeur de fréquence 15 reçoit simultanément un signal SHF à travers le premier module d'amplification/filtrage 19 et génère un premier signal Fl de fréquence fixe.

Par ailleurs, l'étage LNB 1 comporte un module de conversion de fréquence 30 destiné à transposer la fréquence dudit premier signal Fl dans la bande de fréquence correspondant au canal de fonctionnement de l'appareil d'utilisation. Ledit module de conversion de fréquence 30 comporte un deuxième oscillateur local 32 destiné à fournir un signal S2, de fréquence f2 prédéterminée, à au moins un deuxième mélangeur de fréquence (33;34;35) recevant le premier signal Fl, via un deuxième module d'amplification/filtrage 36 et, délivrant à l'unité intérieure 3 via un troisième module d'amplification/filtrage 36a, un deuxième signal Fl ayant une fréquence correspondant au canal de réception sélectionné.

Le deuxième module d'amplification/filtrage 36 comporte un circuit abaisseur de fréquence (37;38;39) (downconverter en langue anglaise) monté en série avec un deuxième filtre de réjection de la bande image (40;41;42).

Dans un deuxième mode de réalisation de l'invention illustré à la figure 7, l'étage LNB 1 comporte deux modules de sélection de la fréquence du canal de réception souhaité, soit le premier module 6 destiné à sélectionner un premier canal de réception parmi la bande de fréquences reçue, et le deuxième module 8 destiné à sélectionner un deuxième canal de réception parmi ladite bande de fréquences reçue. Lesdits premier et deuxième modules sont agencés dans deux branches parallèles et sont reliés respectivement à une première sortie 43 et à une deuxième sortie 44 du premier module d'amplification/filtrage 19. Ce dernier comporte également deux branches parallèles soit une première branche comprenant un premier LNA à large bande 45 relié, à travers un premier élément de commutation 48, à un premier filtre 46, et une deuxième branche comprenant un deuxième LNA à large bande 47 relié, à travers un deuxième élément de commutation 54, à un deuxième filtre 55. Les sorties du premier filtre 46 et du deuxième filtre 55 sont reliées respectivement au premier module 6 et au deuxième module 8 de sélection de la fréquence du canal de réception souhaité. Lesdits premiers et deuxième éléments de commutation 48 et 54 permettent de choisir, pour chaque branche, soit la polarisation H (horizontale), soit la polarisation V (verticale).

Le fonctionnement du dispositif selon l'invention sera expliqué en référence aux figures 6 et 7 dans lesquelles des références identiques sont attribuées aux éléments remplissant des fonctions identiques.

L'antenne extérieure reçoit des signaux situées dans une bande de fréquences SHF (Super High Frequency en langue anglaise). Lesdits signaux sont appliqués, après filtrage et amplification au moyen du premier module d'amplification/filtrage 19, à l'entrée du premier mélangeur de fréquences (15;16;17). Ledit premier mélangeur de fréquences (15;16;17) reçoit, simultanément, le signal S1 de fréquence f1 délivré par le premier oscillateur local (9;10;11), et délivre un premier signal Fl. Ledit premier signal Fl est ensuite appliqué, via le deuxième module d'amplification filtrage 36, au deuxième mélangeur de fréquences (33;34;35), qui reçoit simultanément le signal S2 délivré par le deuxième oscillateur local 32 et délivre le deuxième signal Fl à l'unité intérieure via le troisième module d'amplification/filtrage 36a relié au câble coaxial. Le deuxième oscillateur local 32 génère un signal de fréquence fixe obtenue par multiplication, par un nombre de valeur variable N, de la fréquence d'un signal de fréquence égale approximativement à 2 GHz, délivré par un VCO (Voltage controlled oscillator) intégré au circuit PLL (12;13;14).

Ainsi, grâce au dispositif selon l'invention, et contrairement aux dispositifs de réception traditionnels, le LNB 1 transmet, à l'unité intérieure, uniquement des signaux dont les fréquences sont situées dans la gamme de fréquences de fonctionnement des appareils de réception courants qui sont nettement inférieures aux fréquences reçues par l'antenne. En outre, lesdits signaux sont transmis à travers un seul câble coaxial 2.

L'association, dans le LNB, de l'étage de sélection (4;6;8) de la fréquence des canaux de réception et de l'étage de conversion de fréquence 30 assure une grande flexibilité dans le choix des fréquences transmises au démodulateur permettant ainsi d'utiliser aussi bien un démodulateur numérique qu'un démodulateur analogique.

## Revendications

1. Dispositif de réception d'informations audiovisuelles émises par un satellite ou par une station MMDS comportant un étage LNB (1) solidaire d'une antenne extérieure reliée, par au moins un câble coaxial (2), à une unité intérieure (3) comprenant au moins un appareil de réception fonctionnant dans une gamme de fréquence déterminée, caractérisé en ce que l'étage LNB (1) comporte au moins un module (4;6;8) de sélection de la gamme de fréquence de fonctionnement de l'appareil de réception.

2. Dispositif selon la revendication 1, caractérisé en ce que l'étage LNB (1) délivre à l'unité intérieure (3) uniquement des signaux dont les fréquences sont situées dans la gamme de fréquence sélectionnée.

3. Dispositif selon l'une des revendications 1 ou 2, caractérisé en ce que le module (4;6;8) comporte un premier oscillateur local (9;10;11) commandé par un circuit PLL (12;13;14) et destiné à fournir un signal S1, de fréquence f1 prédéterminée, à un premier mélangeur de fréquence (15;16;17) recevant un signal SHF à travers un premier module d'amplification/filtrage (19) de manière à générer un premier signal Fl de fréquence fixe.

4. Dispositif selon la revendication 3, caractérisé en ce que l'étage LNB (1) comporte, en outre, un étage de conversion de fréquence (30) destiné à transposer la fréquence dudit premier signal Fl dans la bande de fréquence de fonctionnement de l'appareil d'utilisation.

5. Dispositif selon la revendication 4, caractérisé en ce que l'étage de conversion de fréquence (30) comporte au moins un deuxième oscillateur local (32) destiné à fournir un signal S1, de fréquence f1 prédéterminée, à au moins un deuxième mélangeur de fréquence (33;34;35) recevant ledit premier signal Fl, via un deuxième module d'amplification/filtrage (36), de manière à délivrer à l'unité intérieure (3) au moins un deuxième signal Fl dont la fréquence correspond au canal sélectionné.

6. Dispositif selon la revendication 3, caractérisé en ce que le circuit PLL (12;13;14) comporte un VCO délivrant un signal de fréquence 2 GHz.

7. Dispositif selon l'une quelconque des revendications précédentes, caractérisé en ce qu'il comporte un seul câble coaxial (2).

8. Dispositif selon l'une quelconque des revendications précédentes, caractérisé en ce que l'unité intérieure (3) comporte au moins un téléviseur et/ou un magnétoscope.
